# EUROPEAN PATENT SPECIFICATION

(11) **EP 4 224 666 B1**
(45) Date of publication and mention of the grant of the patent: **06.05.2026**
(21) Application number: 22862331.0
(22) Date of filing: 24.08.2022
(51) Int. Cl.: H02J 7/00

(54) **WIRELESS CHARGING APPARATUS**
DRAHTLOSE LADEVORRICHTUNG
APPAREIL DE CHARGE SANS FIL

(30) Priority: 14.12.2021 CN 202123159198 U
(43) Date of publication of application: 09.08.2023
(73) Proprietor: Honor Device Co., Ltd., Shenzhen, Guangdong 518040 (CN)
(72) Inventor: HUANG, Hua, Shenzhen, Guangdong 518040 (CN); ZHANG, Xialing, Shenzhen, Guangdong 518040 (CN); ZHU, Xiaoyong, Shenzhen, Guangdong 518040 (CN); ZHANG, Anle, Shenzhen, Guangdong 518040 (CN)
(74) Representative: Isarpatent
(86) International application number: PCT/CN2022/114626
(87) International publication number: WO 2023/109176

(56) References cited:
- EP-A1- 4 113 779
- WO-A1-2021/088360
- CN-A- 110 932 415
- CN-A- 113 270 922
- CN-U- 208 707 367
- CN-U- 208 738 898
- CN-U- 211 859 633
- CN-U- 212 543 377
- CN-U- 217 159 308
- US-A1- 2021 218 256

## Description

### TECHNICAL FIELD

The present invention relates to the field of wireless charging technologies, and in particular, to a wireless charging device.

### BACKGROUND

In a wireless charging process of an electronic device, a large amount of heat is generated by the electronic device. If charging time is relatively long, the heat may cause damage to both the electronic device and a wireless charging device. An existing low-power wireless charging device is not provided with a heat dissipation structure, or dissipates heat of the electronic device by being in contact with a heat sink; and a high-power wireless charging device dissipates heat of the electronic device by using a fan. However, a heat dissipation effect is not ideal, and needs to be further optimized.
CN 110 932 415 A describes a wireless charger that comprises a transmitting coil, a printed circuit board and a fan, and further comprises a first shell which comprises a surface shell, a first bottom shell, and a supporting base for supporting to-be-charged equipment, a first air outlet is formed in the middle of the surface shell; a second shell which is connected with the first shell to form a first cavity, and a second air outlet is formed in the second shell; a semiconductor cooling plate which is arranged in the first cavity, and the semiconductor cooling plate is provided with a refrigeration surface and a heating surface, the first air outlet is configured to enable airflow cooled by the refrigeration surface to flow out from the first air outlet so as to cool the to-be-charged equipment, and the second air outlet is configured to enable airflow flowing through the heating surface to cool the heating surface and then flow out from the second air outlet.
WO 2021/088360 A1 describes a wireless charging base that comprises: a charging panel used for charging the electronic device and comprising a first ventilation hole and a second ventilation hole, the first ventilation hole being formed in the lower surface of the charging panel, and the second ventilation hole being formed in the side surface of the periphery of the charging panel, wherein an air duct exists between the first ventilation hole and the second ventilation hole; a first bottom plate provided on the upper surface of the charging panel, located at one end of the charging panel and used for supporting the electronic device when the electronic device is charged, the first bottom plate comprising a third ventilation hole, and the third ventilation hole being formed in a first surface of the first bottom plate; and a second bottom plate provided on the lower surface of the charging panel, located at the same end as the first bottom plate and used for supporting the charging panel, the second bottom plate comprising a fourth ventilation hole, and the fourth ventilation hole being formed in the first surface of the second bottom plate, wherein an air duct exists between the third ventilation hole and the fourth ventilation hole.
CN 212 543 377 U describes a wireless charger that includes: a housing, including a contact plate used for contact with the rear surface of the terminal device; a wireless charging module; a first fan, capable of dissipating heat of the wireless charging module, where both the wireless charging module and the first fan are disposed in the housing, and an air intake vent is disposed at a position that is of the housing and that is close to the first fan; and an airflow guide structure, disposed on a side that is of the housing and that is adjacent to the contact plate, where the airflow guide structure extends toward the display surface of the terminal device, the airflow guide structure includes a flow channel, a first air exhaust vent connected to the flow channel is disposed at a position that is of the airflow guide structure and that is close to the display surface of the terminal device, an air vent connected to space in which the first fan is located is disposed at a position that is of the housing and at which the airflow guide structure is disposed, and the air vent is connected to the flow channel.

### SUMMARY

In view of this, it is an object of the present invention to provide a wireless charging device with a good heat dissipation effect, as defined in claim 1. This object is solved by the subject-matter of the independent claim, wherein further embodiments are set out in the dependent claims.

According to a first aspect, this application provides a wireless charging device for charging an electronic device. The wireless charging device includes a housing, a transmit coil, and a heat dissipation assembly. The housing is provided with a panel. The transmit coil is disposed in the housing, and is located on a side of the panel. The housing is configured to place an electronic device to be charged, and the electronic device is at a distance from the panel. The housing is provided with an air vent located under the panel. The heat dissipation assembly includes a semiconductor refrigeration chip and a fan. The semiconductor refrigeration chip includes a cold end and a hot end. The hot end is disposed on the housing. The fan is disposed on the housing, and air blown by the fan passes through the cold end and is blown out from the air vent.

The air blown by the fan passes through the cold end and a temperature of the air is reduced, and the air passes between the panel and the electronic device to reduce a temperature of the electronic device.

The heat dissipation assembly further includes another fan and a first thermally conductive member. The first thermally conductive member is disposed on a side that is of the transmit coil and that is away from the panel; and the another fan is disposed on the housing, and blows air to the first thermally conductive member.

Apparently, in the foregoing implementation, the air blown by the another fan can be blown to the first thermally conductive member, so as to reduce a temperature of the first thermally conductive member, and then reduce a temperature of the transmit coil.

The first thermally conductive member is obliquely disposed above the another fan, and the another fan blows air from an upper side.

Apparently, in the foregoing implementation, the first thermally conductive member is obliquely disposed above the fan, to increase projection of the first thermally conductive member on the fan, so that the air blown by the fan may be directly blown to a larger area of the first thermally conductive member, thereby improving efficiency of reducing the temperature of the first thermally conductive member.

In a possible implementation, the heat dissipation assembly further includes another semiconductor refrigeration chip, and the another semiconductor refrigeration chip is disposed between the transmit coil and the first thermally conductive member, and the cold end faces the transmit coil and the hot end faces the first thermally conductive member.

Apparently, in the foregoing implementation, the another semiconductor refrigeration chip is disposed between the transmit coil and the first thermally conductive member, thereby further improving cooling efficiency of the transmit coil.

A first cavity and a second cavity are disposed in the housing, and the second cavity is located above the first cavity. The fan and the another fan are disposed in the first cavity. In a possible implementation, the transmit coil, the semiconductor refrigeration chip, and the first thermally conductive member are sequentially disposed in the second cavity.

Apparently, in the foregoing implementation, the air blown by the fan and the air blown by the another fan are respectively blown to the first thermally conductive member and between the electronic device and the panel, so that both the electronic device and the wireless charging device are cooled, thereby improving cooling efficiency.

In a possible implementation, the first cavity includes a first segment and a second segment, the second segment extends upward along a curve from the first segment to the air vent, the fan is located in the first segment, and the semiconductor refrigeration chip is located in the second segment.

Apparently, in the foregoing implementation, the second segment extends upward along a curve from the first segment to the air vent, so as to guide the air blown by the fan to be blown out from the air vent, and reduce a force of the air blown by the air vent on the electronic device placed on the housing.

In a possible implementation, the wireless charging device further includes a circuit board, the housing is further provided with a third cavity and an air exhaust vent that communicate with each other, and the third cavity communicates with both the first cavity and the second cavity. The third cavity is located above the first cavity, and is located on a side of the second cavity. The circuit board is electrically connected to the transmit coil, the fan, and the another fan. The circuit board is disposed on the housing, and is located in the third cavity. The air blown by the another fan can be blown to the first thermally conductive member and the circuit board, and is discharged from the air exhaust vent.

Apparently, in the foregoing implementation, the another fan can also blow air to the circuit board, so that a temperature of the circuit board is reduced, and a cooling effect of the wireless charging device is further improved.

According to a second aspect, which is an example not covered by the claims, this application provides a wireless charging device, where the wireless charging device includes a housing, a transmit coil, and a heat dissipation assembly. The housing is provided with a panel. The heat dissipation assembly includes a semiconductor refrigeration chip, a first thermally conductive member, and a fan. The semiconductor refrigeration chip includes a cold end and a hot end. The panel, the transmit coil, the semiconductor refrigeration chip, and the first thermally conductive member are sequentially stacked. The cold end faces the transmit coil, and the hot end faces the first thermally conductive member. The fan is disposed in the housing, and the first thermally conductive member is obliquely disposed above the fan.

The air blown by the fan reduces a temperature of the first thermally conductive member, to improve a cooling effect of a cold end of the semiconductor refrigeration chip that is in contact with the first thermally conductive member, and reduce temperatures of the transmit coil and the panel that are sequentially in contact with the cold end, thereby reducing a temperature of the electronic device that is in contact with the panel.

In a possible implementation, a first cavity and a second cavity are disposed in the housing, and the second cavity is located above the first cavity. The fan is located in the first cavity. The transmit coil, the semiconductor refrigeration chip, and the first thermally conductive member are sequentially disposed in the second cavity.

Apparently, in the foregoing implementation, the third cavity is located above the first cavity, and is located on a side of the second cavity, to enable the air blown by the fan to enter the third cavity from the first cavity and be directly blown to the first thermally conductive member, so as to effectively reduce a temperature of the hot end of the semiconductor refrigeration chip, so that a temperature of the cold end of the semiconductor refrigeration chip is maintained at a lower temperature, or a low-temperature state is maintained for a longer time.

In a possible implementation, the wireless charging device further includes a circuit board, the housing is further provided with a third cavity and an air exhaust vent that communicate with each other, and the third cavity communicates with both the first cavity and the second cavity. The third cavity is located above the first cavity, and is located on a side of the second cavity. The circuit board is electrically connected to the transmit coil and the fan. The circuit board is disposed on the housing, and is located in the third cavity. The air blown by the fan can be blown to the first thermally conductive member and the circuit board, and is discharged from the air exhaust vent.

Apparently, in the foregoing implementation, the fan can also blow air to the circuit board, so that a temperature of the circuit board is reduced, and a cooling effect of the wireless charging device is further improved.

In a possible implementation, the wireless charging device further includes a second thermally conductive member, and the second thermally conductive member is disposed between the transmit coil and the semiconductor refrigeration chip.

Apparently, in the foregoing implementation, when an area of the cold end of the semiconductor refrigeration chip parallel to the panel is smaller than an area of the second thermally conductive member parallel to the panel, the second thermally conductive member can conduct all heat of the transmit coil parallel to a surface of the panel, and then conduct the heat to the semiconductor refrigeration chip, thereby improving cooling efficiency.

In a possible implementation, the heat dissipation assembly further includes a third thermally conductive member, and the third thermally conductive member is disposed between the semiconductor refrigeration chip and the first thermally conductive member.

Apparently, in the foregoing implementation, when an area of the hot end of the semiconductor refrigeration chip parallel to the panel is smaller than an area of the third thermally conductive member parallel to the panel, the third thermally conductive member can conduct all heat of the hot end parallel to the panel, and then conduct the heat to the first thermally conductive member, thereby improving cooling efficiency.

In a possible implementation, the second thermally conductive member or the third thermally conductive member is a thermally conductive structure made of a thermally conductive material that is deformable under pressure.

Apparently, in the foregoing implementation, when one of surfaces of the transmit coil and the semiconductor refrigeration chip that are opposite to each other is uneven because of deformation, a pit, or a bump, the second thermally conductive member is pressed by the transmit coil and the semiconductor refrigeration chip to deform, so as to be evenly in contact with both the transmit coil and the semiconductor refrigeration chip, thereby improving heat conduction efficiency. The third thermally conductive member is a thermally conductive structure made of a thermally conductive material that is deformable under pressure. The third thermally conductive member is pressed by the first thermally conductive member and the semiconductor refrigeration chip to deform, so as to be evenly in contact with both the first thermally conductive member and the semiconductor refrigeration chip, thereby improving heat conduction efficiency.

### BRIEF DESCRIPTION OF DRAWINGS

FIG. 1 is a schematic diagram of a wireless charging device according to an example of this application not covered by the claims;
FIG. 2 is a schematic sectional view of the wireless charging device shown in FIG. 1;
FIG. 3 is a schematic diagram of a wireless charging device according to another embodiment of this application;
FIG. 4 is a schematic sectional view of the wireless charging device shown in FIG. 3;
FIG. 5 is a schematic diagram of a wireless charging device according to another example of this application not covered by the claims; and
FIG. 6 is a schematic sectional view of the wireless charging device shown in FIG. 5.

### Description of reference signs of main components

Wireless charging device: 100, 100a, 100b; Housing: 10, 10a, 10b; Panel: 11; Support part: 12; Spacing part: 13; Air vent: 101; First cavity: 102; First segment: 1021; Second segment: 1022; Second cavity: 103; Third cavity: 104; Air intake vent: 105; Air exhaust vent: 106; Fastener: 14; Transmit coil: 20; Coil body: 21; Soft magnet: 23; Heat dissipation assembly: 30; Semiconductor refrigeration chip: 31, 31a, 31b; Cold end: 311, 311a, 311b; Hot end: 312, 312a, 312b; Fan: 32, 32a, 32b; First thermally conductive member: 33; Second thermally conductive member: 34; Third thermally conductive member: 35; Circuit board: 40; Electronic device: 200.

### DESCRIPTION OF EMBODIMENTS

To further describe technical means and effects that are used by this application to achieve a predetermined application objective, the following describes embodiments with reference to the accompanying drawings and implementations. Apparently, the described embodiments are merely some rather than all of the embodiments of this application.

Unless otherwise defined, all technical and scientific terms used in this specification have the same meaning as those commonly understood by persons skilled in the art of this application. The terms used in the specification of this application are merely intended to describe specific embodiments, and are not intended to limit this application.

Some implementations of this application are described in detail below with reference to the accompanying drawings. If there is no conflict, the following embodiments and features in the embodiments may be mutually combined.

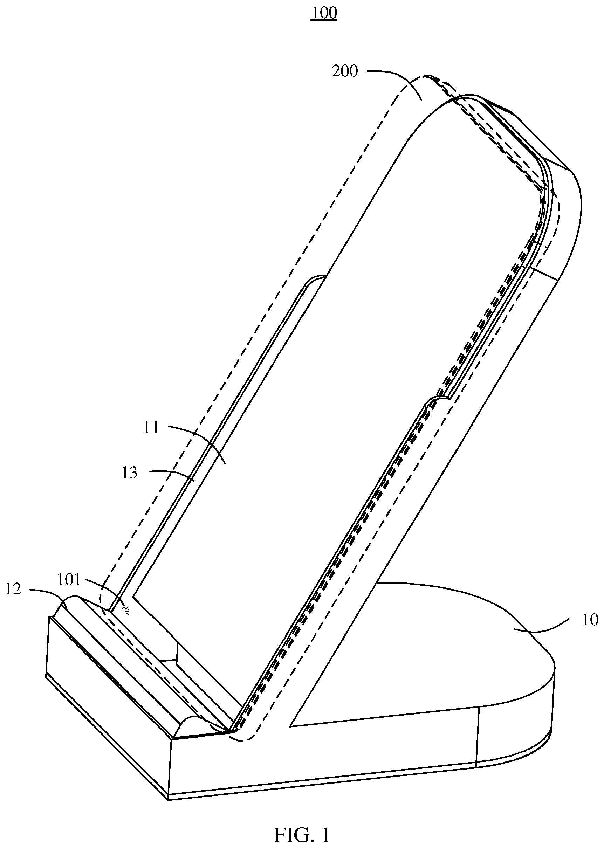

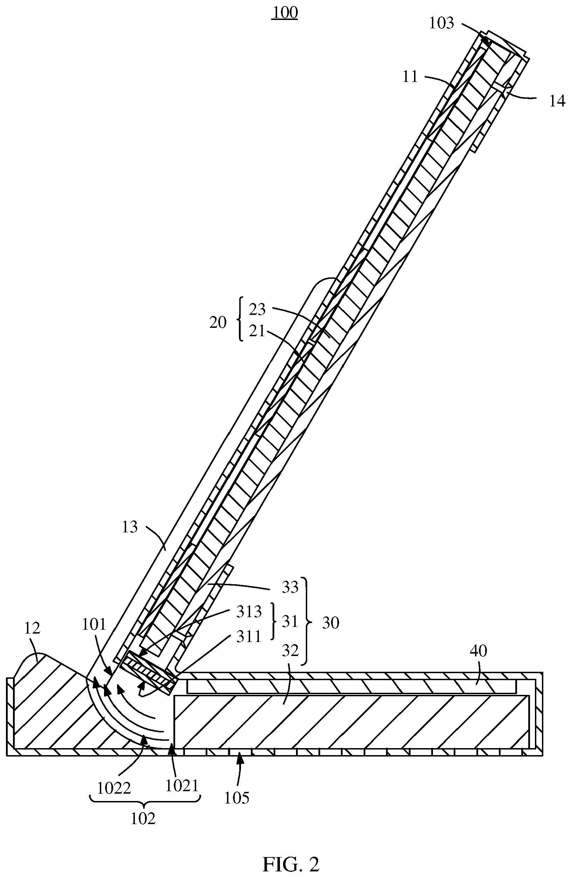

Referring to FIG. 1 and FIG. 2, this application provides a wireless charging device 100. The wireless charging device 100 is configured to charge an electronic device 200. The electronic device 200 may be a mobile phone, a tablet personal computer (Tablet Personal Computer), a laptop computer (Laptop Computer), a personal digital assistant (Personal Digital Assistant, PDA), a mobile Internet device (Mobile Internet Device, MID), a wearable device (Wearable Device), or the like.

The wireless charging device 100 includes a housing 10, a transmit coil 20, and a heat dissipation assembly 30. A first cavity 102 and a second cavity 103 are disposed in the housing 10. The second cavity 103 is located above the first cavity 102. The housing 10 is provided with a panel 11. The transmit coil 20 is disposed in the first cavity 102, and is in contact with one side of the panel 11. The wireless charging device 100 generates an alternating current electromagnetic field when the transmit coil 20 is connected to an alternating current power supply, so that a coil in the electronic device 200 generates an inducting voltage in the alternating current magnetic field, thereby implementing wireless charging on the electronic device 200.

The electronic device 200 is placed on the housing 10, and the electronic device 200 is at a distance from the panel 11, as shown in FIG. 1. The heat dissipation assembly 30 includes a semiconductor refrigeration chip 31 and a fan 32. The semiconductor refrigeration chip 31 and the fan 32 are separately disposed in the first cavity 102. The housing 10 is further provided with an air vent 101 communicating with the first cavity 102. The air vent 101 is located under the panel 11. The semiconductor refrigeration chip 31 is made based on a Peltier (Peltier) effect of a semiconductor material. The Peltier effect refers to a phenomenon that one end absorbs heat and the other end dissipates heat when a direct current passes through a galvanic couple formed by two different semiconductor materials in series. The semiconductor refrigeration chip 31 made based on this principle includes a cold end 311 and a hot end 312 that are on opposite sides. The cold end 311 may cool adjacent components, and heat is transferred through the hot end 312. The semiconductor refrigeration chip 31 is disposed on the housing 10, and is located in the first cavity 102. The hot end 312 of the semiconductor refrigeration chip 31 is fixedly connected to the housing 10, and the cold end 311 protrudes into the first cavity 102. The air blown by the fan 32 passes through the cold end 311 and is blown out from the air vent 101.

A temperature of the air that passes through the cold end 311 is reduced, and the air passes between the panel 11 and the electronic device 200 to reduce a temperature of the electronic device 200.

The panel 11 is made of an insulating and heat-insulation material (for example, a glass fiber or a vacuum plate). Heat generated by the transmit coil 20 is not conducted between the panel 11 and the electronic device 200 through the panel 11, so that cooling of the electronic device 200 by the air blown from the air vent 101 is improved.

It may be understood that, in another embodiment, the panel 11 may alternatively be made of an insulating and thermally conductive non-metallic material, such as a carbon fiber material or a ceramic material. The air blown from the air vent 101 may cool both the panel 11 and the electronic device 200, and the cooling of the panel 11 reduces a temperature of the transmit coil 20.

The fan 32 and the semiconductor refrigeration chip 31 are located in the first cavity 102. The semiconductor refrigeration chip 31 is closer to the air vent 101 than the fan 32. An air intake vent 105 is disposed at the bottom of the housing 10. The air intake vent 105 is located on a side that is of the first cavity 102 and that is away from the second cavity 103. The air intake vent 105 communicates with the first cavity 102. Air enters the first cavity 102 from the air intake vent 105, and the fan 32 guides the air to blow between the electronic device 200 and the panel 11 through the air vent.

It may be understood that, in another embodiment, the air intake vent 105 may alternatively be disposed on a side that is of the first cavity 102 and that is away from the air vent 101. A position of the air intake vent 105 on the first cavity 102 may be set based on an air guiding direction of the fan 32, provided that the fan 32 can guide air entering from the air intake vent 105 to be blown out of the air vent 101.

There is one semiconductor refrigeration chip 31 and the hot end 312 of the semiconductor refrigeration chip 31 is disposed on a cavity wall that is of the first cavity 102 and that faces the second cavity 103, but is not limited thereto. For example, in another embodiment, there are two semiconductor refrigeration chips 31. The two semiconductor refrigeration chips 31 are disposed opposite to each other on two opposite cavity walls of the first cavity 102, and cold ends 311 of the two semiconductor refrigeration chips are disposed opposite to each other. The air blown by the fan 32 is blown to the cold ends 311 of the two semiconductor refrigeration chips 31, so that the air blown between the electronic device 200 and the panel 11 is quickly cooled, thereby improving efficiency of reducing a temperature of the electronic device 200.

The housing 10 is further provided with a support part 12 on a side of the air vent 101. The support part 12 is configured to support the electronic device 200. The housing 10 is further provided with a spacing part 13. There are two spacing parts 13. The two spacing parts 13 are disposed at intervals and protrude from the panel 11. The spacing part 13 is configured to be in contact with the electronic device 200, so that there is a distance between the electronic device 200 and the panel 11.

It may be understood that, in another embodiment, a quantity of spacing parts 13 may be one or another number. Provided that the spacing part 13 protrudes from the panel 11, the electronic device 200 is placed on the housing 10, and is in contact with the spacing part 13, so that there is a distance between the electronic device 200 and the panel 11.

The first cavity 102 includes a first segment 1021 and a second segment 1022 that communicate with each other. The fan 32 is disposed in the first segment 1021. The second segment 1022 is closer to the air vent 101 than the first segment 1021. The second segment 1022 extends upward along a curve from the first segment 1021 to the air vent 101, so as to guide the air blown by the fan 32 to blow out from the air vent 101, and reduce a force of the air blown by the air vent 101 on the electronic device 200 placed on the housing 10. The fan 32 blows air in a direction of the first segment 1021 toward the second segment 1022.

It may be understood that, in another embodiment, the first segment 1021 may alternatively be obliquely disposed along a straight line, or the first segment 1021 extends from the second segment 1022 to the air vent 101 along two straight paths that intersect along an L-shape or a V-shape.

The heat dissipation assembly 30 further includes a first thermally conductive member 33. The first thermally conductive member 33 is disposed on the housing 10, and is located in the first cavity 102. The panel 11, the transmit coil 20, and the first thermally conductive member 33 are sequentially stacked, and sequentially transmit heat.

The first thermally conductive member 33 may be separated from the housing 10, and the first thermally conductive member 33 is exposed from the housing 10 and is in contact with air outside the housing 10. The first thermally conductive member 33 may be in an integrated structure with the housing 10, and the first thermally conductive member 33 is in contact with the air outside the housing 10.

Heat of the transmit coil 20 is conducted to the first thermally conductive member 33, and the first thermally conductive member 33 dissipates the heat to the outside of the first cavity 102.

It may be understood that, in another embodiment, the first thermally conductive member 33 may alternatively be omitted.

The transmit coil 20 includes a coil body 21 and a soft magnet 23. The panel 11, the coil body 21, and the soft magnet 23 are sequentially disposed. The soft magnet 23 can improve strength of a magnetic field generated when the coil body 21 is energized.

The soft magnet 23 is made of a soft magnetic material, for example, the soft magnet 23 may be made of a ferrite or an iron-based amorphous alloy.

The transmit coil 20 and the first thermally conductive member 33 may be separately connected to the housing 10 in an adhesive manner, but is not limited thereto. For example, as shown in FIG. 2, the first thermally conductive member 33 is locked on the housing 10 by using a fastener 14 such as a screw, so that the first thermally conductive member 33 and the panel 11 are respectively pressed against both sides of the transmit coil 20, and the transmit coil 20 and the first thermally conductive member 33 are fastened to the housing 10, thereby avoiding impact of heat-conducting property of adhesive on heat conduction efficiency of the transmit coil 20 and the first thermally conductive member 33.

The wireless charging device 100 further includes a circuit board 40. The circuit board 40 is disposed on the housing 10, and is located in the first cavity 102. The circuit board 40 is located on a side that is of the fan 32 and that is away from the air intake vent 105, and the circuit board 40 is electrically connected to the transmit coil 20, the fan 32, and the semiconductor refrigeration chip 31, so as to control the transmit coil 20, the fan 32, and the semiconductor refrigeration chip 31 to operate.

In the wireless charging device 100, the air blown by the fan 32 passes through the cold end 311 of the semiconductor refrigeration chip 31, so that the air cools down and passes through the air vent 101 to flow between the panel 11 and the electronic device 200, thereby improving a cooling effect of the electronic device 200.

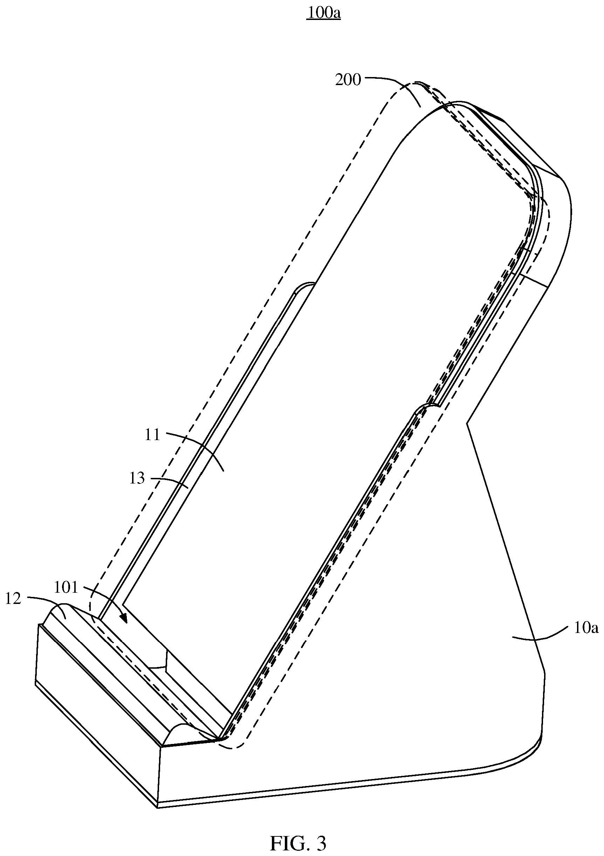

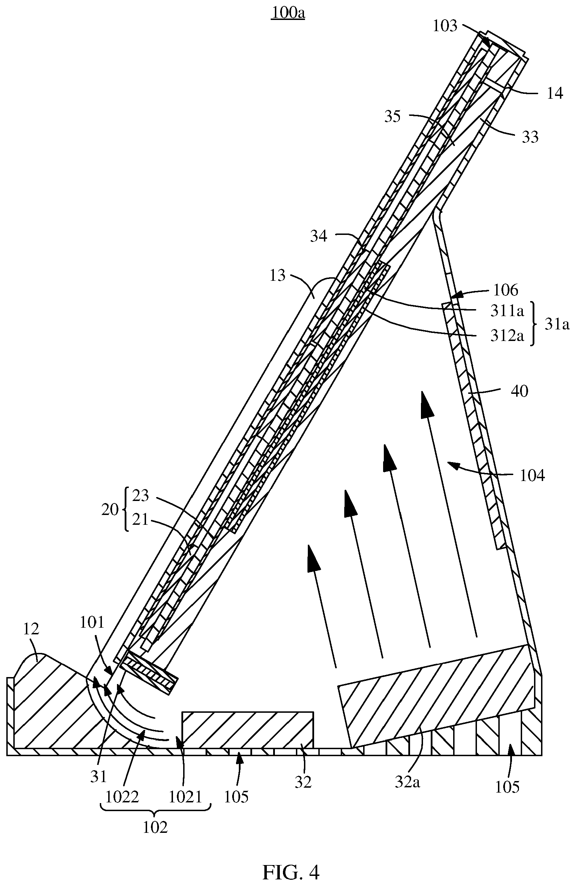

Referring to FIG. 3 and FIG. 4, a difference between a wireless charging device 100a in another embodiment and the wireless charging device 100 lies in that the wireless charging device 100a further includes another fan 32a and another semiconductor refrigeration chip 31a, and a structure of a housing 10 of the wireless charging device 100a is different from a structure of a housing 10a of the wireless charging device 100a.

The semiconductor refrigeration chip 31a is stacked on a side of a transmit coil 20 and a first thermally conductive member 33. The fan 32a is disposed on a first housing, and is located in a first cavity 102, but is not limited thereto. The fan 32a is located on a side that is of the fan 32a and that is away from the semiconductor refrigeration chip 31a.

The housing 10a is further provided with a third cavity 104 and an air exhaust vent 106. The third cavity 104 communicates with both the first cavity 102 and a second cavity 103. The third cavity 104 is located above the first cavity 102, and is located on a side of the second cavity 103. The air exhaust vent 106 is located on a side that is of the third cavity 104 and that is away from the first thermally conductive member 33. The air blown by the fan 32a can be blown to the first thermally conductive member 33 and discharged from the air exhaust vent 106, thereby reducing a temperature of the first thermally conductive member 33, and then reducing a temperature of the transmit coil 20.

The first thermally conductive member 33 is obliquely disposed above the fan 32a, to increase projection of the first thermally conductive member 33 on the fan 32a, so that the air blown by the fan 32a may be directly blown to a larger area of the first thermally conductive member 33, thereby improving efficiency of reducing the temperature of the first thermally conductive member 33.

The air blown by the fan 32a and the air blown by the fan 32 respectively are respectively blown to the first thermally conductive member 33 and between the electronic device 200 and the panel 11, so that both the electronic device 200 and the wireless charging device 100 are cooled, thereby improving cooling efficiency.

The wireless charging device 100a further includes a circuit board 40. The circuit board 40 is disposed on the housing 10a, and is located on a cavity wall that is of the third cavity 104 and that is away from the first thermally conductive member 33. The circuit board 40 is electrically connected to the transmit coil 20, the fan 32a, and the fan 32a. The circuit board 40 is obliquely disposed above the fan 32a, so that the air blown by the fan 32a can be blown to the circuit board 40, and the circuit board 40 is cooled.

The wireless charging device 100a further includes a second thermally conductive member 34, and the second thermally conductive member 34 is disposed between the transmit coil 20 and the semiconductor refrigeration chip 31a. The second thermally conductive member 34 is a thermally conductive structure made of a thermally conductive material that is deformable under pressure. For example, the second thermally conductive member 34 is a sheet-like structure made of thermally conductive silicone. Hardness of the transmit coil 20 and hardness of the semiconductor refrigeration chip 31a are greater than hardness of the second thermally conductive member 34. When one of surfaces of the transmit coil 20 and the semiconductor refrigeration chip 31a that are opposite to each other is uneven because of deformation, a pit, or a bump, the second thermally conductive member 34 is pressed by the transmit coil 20 and the semiconductor refrigeration chip 31a to deform, so as to be evenly in contact with both the transmit coil 20 and the semiconductor refrigeration chip 31a, thereby improving heat conduction efficiency.

It may be understood that, in another embodiment, the second thermally conductive member 34 may alternatively be made of a hard thermally conductive material. When an area of a cold end 311a of the semiconductor refrigeration chip 31a parallel to the panel 11 is smaller than an area of the second thermally conductive member 34 parallel to the panel 11, the second thermally conductive member 34 can conduct all heat of the transmit coil 20 parallel to the panel 11, and then conduct the heat to the semiconductor refrigeration chip 31a, thereby improving cooling efficiency.

It may be understood that, in another embodiment, when an area of the cold end 311a and the hot end 312a that are of the semiconductor refrigeration chip 31a parallel to the panel 11 is more than 50% of an area of the transmit coil 20 parallel to the panel 11, both the first thermally conductive member 33 and the second thermally conductive member 34 may be omitted.

The heat dissipation assembly 30 further includes a third thermally conductive member 35, and the third thermally conductive member 35 is disposed between the semiconductor refrigeration chip 31a and the first thermally conductive member 33. The third thermally conductive member 35 is a thermally conductive structure made of a thermally conductive material that is deformable under pressure. The third thermally conductive member 35 is pressed by the first thermally conductive member 33 and the semiconductor refrigeration chip 31a to deform, so as to be evenly in contact with both the first thermally conductive member 33 and the semiconductor refrigeration chip 31a, thereby improving heat conduction efficiency.

It may be understood that, in another embodiment, the semiconductor refrigeration chip 31a may alternatively be omitted. Heat of the transmit coil 20 is conducted to the first thermally conductive member 33, and the fan 32a blows air to the first thermally conductive member 33, which can also reduce a temperature of the first thermally conductive member 33.

In the wireless charging device 100a, the air blown by the fan 32 passes through the cold end 311 of the semiconductor refrigeration chip 31, so that the air cools down and passes through the air vent 101 to flow between the panel 11 and the electronic device 200, thereby improving a cooling effect of the electronic device 200. In the wireless charging device 100a, the air is blown to the first thermally conductive member 33 through the fan 32a, a temperature of the transmit coil 20 is reduced through heat conduction between the first thermally conductive member 33 and the transmit coil 20. The wireless charging device 100a can cool both the electronic device 200 and the transmit coil 20.

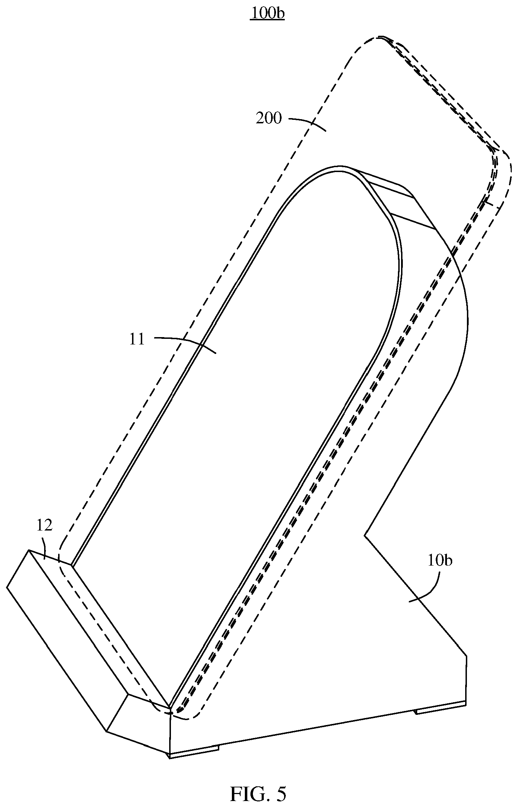

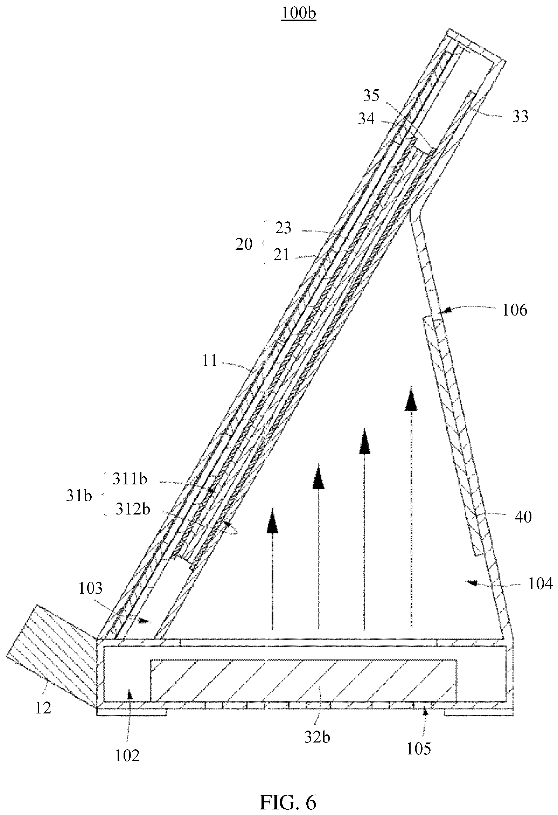

Referring to FIG. 5 and FIG. 6, in still another embodiment, a wireless charging device 100b includes a housing 10ab, a transmit coil 20, and a heat dissipation assembly 30. The housing 10ab is provided with a panel 11. The heat dissipation assembly 30 includes a semiconductor refrigeration chip 31b, a first thermally conductive member 33, and a fan 32b. The semiconductor refrigeration chip 31b includes a cold end 311b and a hot end 312b. The panel 11, the transmit coil 20, the semiconductor refrigeration chip 31b, and the first thermally conductive member 33 are sequentially stacked. The cold end 311b faces the transmit coil 20. The hot end 312b faces the first thermally conductive member 33. The fan 32b is disposed in the housing 10ab. The first thermally conductive member 33 is obliquely disposed above the fan 32b, to increase projection of the first thermally conductive member 33 on the fan 32b, so that the air blown by the fan 32b may be directly blown to a larger area of the first thermally conductive member 33, thereby improving efficiency of reducing a temperature of the first thermally conductive member 33.

The panel 11 is made of an insulating and thermally conductive non-metallic material, such as a carbon fiber material or a ceramic material.

The housing 10ab is further provided with a support part 12 located under the panel 11. The support part 12 is configured to support the electronic device 200, so that the electronic device 200 is placed on the housing 10ab, and is in contact with the panel 11.

The air blown by the fan 32b reduces a temperature of the first thermally conductive member 33, to improve a cooling effect of the cold end 311b of the semiconductor refrigeration chip 31b that is in contact with the first thermally conductive member 33, and then reduce temperatures of the transmit coil 20 and the panel 11 that are sequentially in contact with the cold end 311b, thereby reducing a temperature of the electronic device 200 that is in contact with the panel 11.

A first cavity 102, a second cavity 103, and a third cavity 104 are disposed in the housing 10ab. The second cavity 103 is located above the first cavity 102. The fan 32b is located in the first cavity 102. The transmit coil 20, the semiconductor refrigeration chip 31b, and the first thermally conductive member 33 are sequentially disposed in the second cavity 103. The housing 10ab is further provided with an air exhaust vent 106, and the air exhaust vent 106 communicates with the third cavity 104. An air intake vent 105 communicating with the first cavity 102 is disposed at the bottom of the housing 10ab. The third cavity 104 communicates with both the first cavity 102 and a second cavity 103.

The third cavity 104 is located above the first cavity 102, and is located on a side of the second cavity 103, to enable the air blown by the fan 32b to enter the third cavity 104 from the first cavity 102 and be directly blown to the first thermally conductive member 33, so as to effectively reduce a temperature of the hot end 312b of the semiconductor refrigeration chip 31b, so that a temperature of the cold end 311b of the semiconductor refrigeration chip 31b is maintained at a lower temperature, or a low-temperature state is maintained for a longer time. Air enters the first cavity 102 from the air intake vent 105, is blown out from the fan 32b and is blown to the first thermally conductive member 33, and then is discharged from the air exhaust vent 106.

The wireless charging device 100b further includes a circuit board 40. The circuit board 40 is disposed on the housing 10ab, and is located in the third cavity 104. The circuit board 40 is electrically connected to the transmit coil 20 and the fan 32b. The circuit board 40 is obliquely disposed above the fan 32b, so that the air blown by the fan 32b can be blown to the circuit board 40, and the circuit board 40 is cooled.

The wireless charging device 100b further includes a second thermally conductive member 34, and the second thermally conductive member 34 is disposed between the transmit coil 20 and the semiconductor refrigeration chip 31b. The second thermally conductive member 34 is a thermally conductive structure made of a thermally conductive material that is deformable under pressure. For example, the second thermally conductive member 34 is a sheet-like structure made of thermally conductive silicone. Hardness of the transmit coil 20 and hardness of the semiconductor refrigeration chip 31b are greater than hardness of the second thermally conductive member 34. When one of surfaces of the transmit coil 20and the semiconductor refrigeration chip 31a that are opposite to each other is uneven because of deformation, a pit, or a bump, the second thermally conductive member 34 is pressed by the transmit coil 20 and the semiconductor refrigeration chip 31b to deform, so as to be evenly in contact with both the transmit coil 20 and the semiconductor refrigeration chip 31b, thereby improving heat conductive efficiency.

It may be understood that, in another embodiment, the second thermally conductive member 34 may alternatively be made of a hard thermally conductive material. When an area of the cold end 311b of the semiconductor refrigeration chip 31b parallel to the panel 11 is smaller than an area of the second thermally conductive member 34 parallel to the panel 11, the second thermally conductive member 34 can conduct all heat of the transmit coil 20 parallel to the panel 11, and then conduct the heat to the semiconductor refrigeration chip 31b, thereby improving cooling efficiency.

It may be understood that, in another embodiment, when an area of the cold end 311b and the hot end 312b that are of the semiconductor refrigeration chip 31b parallel to the panel 11 is more than 50% of an area of the transmit coil 20 parallel to the panel 11, both the first thermally conductive member 33 and the second thermally conductive member 34 may be omitted.

The heat dissipation assembly 30 further includes a third thermally conductive member 35, and the third thermally conductive member 35 is disposed between the semiconductor refrigeration chip 31b and the first thermally conductive member 33. When an area of the hot end 312b of the semiconductor refrigeration chip 31b parallel to the panel 11 is smaller than an area of the third thermally conductive member 35 parallel to the panel 11, the third thermally conductive member 35 can conduct all heat of the hot end 312b parallel to the panel 11, and then conduct the heat to the first thermally conductive member 33, thereby improving cooling efficiency.

The third thermally conductive member 35 is a thermally conductive structure made of a thermally conductive material that is deformable under pressure. The third thermally conductive member 35 is pressed by the first thermally conductive member 33 and the semiconductor refrigeration chip 31b to deform, so as to be evenly in contact with both the first thermally conductive member 33 and the semiconductor refrigeration chip 31b, thereby improving heat conductive efficiency.

The wireless charging device 100b cools the transmit coil 20, the panel 11, and the electronic device 200 that are sequentially in contact with each other through the cold end 311b of the semiconductor refrigeration chip 31b, and the fan 32b blows air to the first thermally conductive member 33, so that the hot end 312b that is in contact with the first thermally conductive member 33 is cooled, thereby improving a cooling effect.

The wireless charging device 100, the wireless charging device 100a, and the wireless charging device 100b may charge the electronic device, and a heat dissipation effect is good in a charging process. For example, the electronic device is a mobile phone, a tablet computer, a headset, a headset case, or a smartwatch.

## Claims

1. A wireless charging device (100a) for charging an electronic device (200), comprising a housing (10a), a transmit coil (20), and a heat dissipation assembly (30), wherein the housing (10) is provided with a panel (11), and the transmit coil (20) is disposed in the housing (10), and is located on a side of the panel (11);
the housing (10a) is configured to place the electronic device (200) to be charged onto the panel (11), and make the electronic device (200) have a distance from the panel (11);
the housing (10a) is provided with a first cavity (102), a second cavity (103) and a third cavity (104),
the housing (10a) is provided with an air inlet (105) and an air outlet (101) both communicating with the first cavity (102) and located below the panel (11),
the third cavity (104) communicates with the first cavity (102) and the second cavity (103) respectively,
the third cavity (104) is located above the first cavity (102) and at one side of the second cavity (103),
the housing (10a) is provided with a further air outlet (106), located on a side of the third cavity (104) away from a first heat conducting member (33),
the transmit coil (20) is disposed in the second cavity (103) and contacts one side of the panel (11),
the heat dissipation assembly (30) comprises:
- a semiconductor refrigeration chip (31) and a fan (32) disposed in the first cavity (102), the semiconductor refrigeration chip (31) comprising a cold end (311) and a hot end (312), wherein the hot end (312) is disposed on the housing (10a), and air blown by the fan (32) passes through the cold end (311) and is blown out from the air outlet (101), such that air enters the first cavity (102) from the air inlet (105), and the fan (32) guides the air to blow to the space between the electronic device (200) and the panel (11),
- a first thermally conductive member (33) located in the second cavity (103), disposed on a side that is of the transmit coil (20) and that is away from the panel (11), wherein the panel (11), the transmit coil (20) and the first thermally conductive member (33) are stacked in sequence and conduct heat in sequence; and
the heat dissipation assembly (30) further comprises:
- another fan (32a) and another semiconductor refrigeration chip (31a), wherein
the another semiconductor refrigeration chip (31a) is stacked on one side of the transmit coil (20) and the first thermally conductive member (33), and
the another fan (32a) is disposed on the housing (10a) and located in the first cavity (102),
the wind blown by the another fan (32) is blown to the first thermally conductive member (33) and discharged from the air outlet (106),
the first thermally conductive member (33) is obliquely disposed above the another fan (32a),so that the projection of the first thermally conductive member (33) on the another fan (32a) is enlarged and the air blown by the another fan (32a) can be directly blown to a larger area of the first thermally conductive member (33).

2. The wireless charging device according to claim 1, wherein the another semiconductor refrigeration chip (31a) is disposed between the transmit coil (20) and the first thermally conductive member (33), the cold end (311) faces the transmit coil (20), and the hot end (312) faces the first thermally conductive member (33).

3. The wireless charging device according to claim 1, wherein the first cavity (102) comprises a first segment (1021) and a second segment (1022), the second segment (1022) extends upward along a curve from the first segment (1021) to the air vent (101), the fan (32) is located in the first segment (1021), and the semiconductor refrigeration chip (31) is located in the second segment (1022).

4. The wireless charging device according to claim 1, wherein the wireless charging device (100) further comprises a circuit board (40), and
the circuit board (40) is electrically connected to the transmit coil (20), the fan (32), and the another fan (32a), the circuit board (40) is disposed on the housing (10a), and is located in the third cavity (104), and air blown by the another fan (32a) can be blown to the first thermally conductive member (33) and the circuit board (40), and is discharged from the air exhaust vent (106).

5. The wireless charging device according to any one of claims 1 to 4, wherein the wireless charging device (100) further comprises a second thermally conductive member (34), and the second thermally conductive member (34) is disposed between the transmit coil (20) and the semiconductor refrigeration chip (31).

6. The wireless charging device according to claim 5, wherein the heat dissipation assembly (30) further comprises a third thermally conductive member (35), and the third thermally conductive member (35) is disposed between the semiconductor refrigeration chip (31) and the first thermally conductive member (33).

7. The wireless charging device according to claim 6, wherein the second thermally conductive member (34) or the third thermally conductive member (35) is a thermally conductive structure made of a thermally conductive material that is deformable under pressure.

8. The wireless charging device according to any one of the preceding claims, wherein the another fan (32a) and the first thermally conductive member (33) are arranged relatively to each other so that air blown by the another fan (32a) is obliquely blown directly onto a cover or base side of the first thermally conductive member (33).

## Patentansprüche

1. Drahtlose Ladevorrichtung (100a) zum Laden einer elektronischen Vorrichtung (200), umfassend ein Gehäuse (10a), eine Sendespule (20) und eine Wärmeableitungsanordnung (30), wobei das Gehäuse (10) mit einer Platte (11) versehen ist und die Sendespule (20) im Gehäuse (10) angeordnet ist und sich auf einer Seite der Platte (11) befindet;
das Gehäuse (10a) dazu konfiguriert ist, die zu ladende elektronische Vorrichtung (200) auf der Platte (11) zu platzieren und zu bewirken, dass die elektronische Vorrichtung (200) einen Abstand von der Platte (11) aufweist;
das Gehäuse (10a) mit einem ersten Hohlraum (102), einem zweiten Hohlraum (103) und einem dritten Hohlraum (104) versehen ist,
das Gehäuse (10a) mit einem Lufteinlass (105) und einem Luftauslass (101) versehen ist, die beide mit dem ersten Hohlraum (102) in Verbindung stehen und sich unterhalb der Platte (11) befinden,
der dritte Hohlraum (104) jeweils mit dem ersten Hohlraum (102) und dem zweiten Hohlraum (103) in Verbindung steht,
der dritte Hohlraum (104) oberhalb des ersten Hohlraums (102) und an einer Seite des zweiten Hohlraums (103) angeordnet ist,
das Gehäuse (10a) mit einem weiteren Luftauslass (106) versehen ist, der sich auf einer Seite des dritten Hohlraums (104) entfernt von einem ersten Wärmeleitelement (33) befindet,
die Sendespule (20) im zweiten Hohlraum (103) angeordnet ist und eine Seite der Platte (11) kontaktiert,
die Wärmeableitungsanordnung (30) umfasst:
- einen Halbleiter-Kühlchip (31) und einen Lüfter (32), die im ersten Hohlraum (102) angeordnet sind, wobei der Halbleiter-Kühlchip (31) ein kaltes Ende (311) und ein heißes Ende (312) umfasst, wobei das heiße Ende (312) am Gehäuse (10a) angeordnet ist und vom Lüfter (32) geblasene Luft durch das kalte Ende (311) strömt und aus dem Luftauslass (101) ausgeblasen wird, sodass Luft durch den Lufteinlass (105) in den ersten Hohlraum (102) eintritt und der Lüfter (32) die Luft so leitet, dass sie in den Raum zwischen der elektronischen Vorrichtung (200) und der Platte (11) bläst,
- ein erstes wärmeleitendes Element (33), das sich im zweiten Hohlraum (103) befindet und auf einer Seite der Sendespule (20) angeordnet ist, die von der Platte (11) abgewandt ist, wobei die Platte (11), die Sendespule (20) und das erste wärmeleitende Element (33) nacheinander gestapelt sind und Wärme nacheinander leiten; und
die Wärmeableitungsanordnung (30) ferner umfasst:
- einen weiteren Lüfter (32a) und einen weiteren Halbleiter-Kühlchip (31a), wobei
der weitere Halbleiter-Kühlchip (31a) auf einer Seite der Sendespule (20) und dem ersten wärmeleitenden Element (33) gestapelt ist, und
der weitere Lüfter (32a) am Gehäuse (10a) angeordnet ist und sich im ersten Hohlraum (102) befindet,
Der vom weiteren Lüfter (32) geblasene Wind wird auf das erste wärmeleitende Element (33) geblasen und aus dem Luftauslass (106) abgeführt,
Das erste wärmeleitende Element (33) ist schräg über dem weiteren Lüfter (32a) angeordnet, sodass die Projektion des ersten wärmeleitenden Elements (33) auf den weiteren Lüfter (32a) vergrößert wird und die vom weiteren Lüfter (32a) geblasene Luft direkt auf einen größeren Bereich des ersten wärmeleitenden Elements (33) geblasen werden kann.

2. Drahtlose Ladevorrichtung nach Anspruch 1, wobei der weitere Halbleiter-Kühlchip (31a) zwischen der Sendespule (20) und dem ersten wärmeleitenden Element (33) angeordnet ist, die kalte Seite (311) der Sendespule (20) zugewandt ist und die heiße Seite (312) dem ersten wärmeleitenden Element (33) zugewandt ist.

3. Drahtlose Ladevorrichtung nach Anspruch 1, wobei der erste Hohlraum (102) ein erstes Segment (1021) und ein zweites Segment (1022) umfasst, wobei sich das zweite Segment (1022) entlang einer Kurve vom ersten Segment (1021) zum Luftauslass (101) nach oben erstreckt, der Lüfter (32) im ersten Segment (1021) angeordnet ist und der Halbleiter-Kühlchip (31) im zweiten Segment (1022) angeordnet ist.

4. Drahtlose Ladevorrichtung nach Anspruch 1, wobei die drahtlose Ladevorrichtung (100) ferner eine Leiterplatte (40) umfasst und
die Leiterplatte (40) elektrisch mit der Sendespule (20), dem Lüfter (32) und dem weiteren Lüfter (32a) verbunden ist, die Leiterplatte (40) am Gehäuse (10a) angeordnet und im dritten Hohlraum (104) untergebracht ist und die vom weiteren Lüfter (32a) geblasene Luft auf das erste wärmeleitende Element (33) und die Leiterplatte (40) geblasen werden kann und aus dem Luftauslass (106) abgeführt wird.

5. Drahtlose Ladevorrichtung nach einem der Ansprüche 1 bis 4, wobei die drahtlose Ladevorrichtung (100) ferner ein zweites wärmeleitendes Element (34) umfasst und das zweite wärmeleitende Element (34) zwischen der Sendespule (20) und dem Halbleiter-Kühlchip (31) angeordnet ist.

6. Drahtlose Ladevorrichtung nach Anspruch 5, wobei die Wärmeableitungsanordnung (30) ferner ein drittes wärmeleitendes Element (35) umfasst und das dritte wärmeleitende Element (35) zwischen dem Halbleiter-Kühlchip (31) und dem ersten wärmeleitenden Element (33) angeordnet ist.

7. Drahtlose Ladevorrichtung nach Anspruch 6, wobei das zweite wärmeleitende Element (34) oder das dritte wärmeleitende Element (35) eine wärmeleitende Struktur ist, die aus einem wärmeleitenden Material besteht, das unter Druck verformbar ist.

8. Drahtlose Ladevorrichtung nach einem der vorhergehenden Ansprüche, wobei der weitere Lüfter (32a) und das erste wärmeleitende Element (33) relativ zueinander so angeordnet sind, dass von dem weiteren Lüfter (32a) geblasene Luft schräg direkt auf eine Abdeckungs- oder Basisseite des ersten wärmeleitenden Elements (33) geblasen wird.

## Revendications

1. Dispositif de recharge sans fil (100a) pour recharger un dispositif électronique (200), comprenant un boîtier (10a), une bobine d'émission (20) et un ensemble de dissipation thermique (30), dans lequel le boîtier (10) est pourvu d'un panneau (11), et la bobine d'émission (20) est disposée dans le boîtier (10) et est située sur un côté du panneau (11) ;
le boîtier (10a) est configuré pour placer le dispositif électronique (200) à recharger sur le panneau (11), et pour que le dispositif électronique (200) soit à une distance du panneau (11) ;
le boîtier (10a) est pourvu d'une première cavité (102), d'une deuxième cavité (103) et d'une troisième cavité (104),
le boîtier (10a) est pourvu d'une entrée d'air (105) et d'une sortie d'air (101) communiquant toutes deux avec la première cavité (102) et situées sous le panneau (11),
la troisième cavité (104) communique respectivement avec la première cavité (102) et la deuxième cavité (103),
la troisième cavité (104) est située au-dessus de la première cavité (102) et sur un côté de la deuxième cavité (103),
le boîtier (10a) est pourvu d'une sortie d'air supplémentaire (106), située sur un côté de la troisième cavité (104) à l'opposé d'un premier élément conducteur thermique (33),
la bobine d'émission (20) est disposée dans la deuxième cavité (103) et est en contact avec un côté du panneau (11),
l'ensemble de dissipation thermique (30) comprend :
- une puce de réfrigération à semi-conducteur (31) et un ventilateur (32) disposés dans la première cavité (102), la puce de réfrigération à semi-conducteur (31) comprenant une extrémité froide (311) et une extrémité chaude (312), dans lequel l'extrémité chaude (312) est disposée sur le boîtier (10a), et l'air soufflé par le ventilateur (32) passe à travers l'extrémité froide (311) et est soufflé hors de la sortie d'air (101), de telle sorte que l'air entre dans la première cavité (102) depuis l'entrée d'air (105), et le ventilateur (32) guide l'air pour qu'il souffle dans l'espace entre le dispositif électronique (200) et le panneau (11),
- un premier élément thermoconducteur (33) situé dans la deuxième cavité (103), disposé sur un côté qui est celui de la bobine d'émission (20) et qui est éloigné du panneau (11), dans lequel le panneau (11), la bobine d'émission (20) et le premier élément thermoconducteur (33) sont empilés en séquence et conduisent la chaleur en séquence ; et
l'ensemble de dissipation thermique (30) comprend en outre :
- un autre ventilateur (32a) et une autre puce de réfrigération à semi-conducteur (31a), dans lequel
l'autre puce de réfrigération à semi-conducteur (31a) est empilée sur un côté de la bobine d'émission (20) et du premier élément thermoconducteur (33), et
l'autre ventilateur (32a) est disposé sur le boîtier (10a) et situé dans la première cavité (102),
le vent soufflé par l'autre ventilateur (32) est soufflé vers le premier élément thermoconducteur (33) et évacué par la sortie d'air (106),
le premier élément thermoconducteur (33) est disposé obliquement au-dessus de l'autre ventilateur (32a), de sorte que la projection du premier élément thermoconducteur (33) sur l'autre ventilateur (32a) est agrandie et l'air soufflé par l'autre ventilateur (32a) peut être directement soufflé vers une zone plus large du premier élément thermoconducteur (33).

2. Le dispositif de charge sans fil selon la revendication 1, dans lequel l'autre puce de réfrigération à semi-conducteur (31a) est disposée entre la bobine d'émission (20) et le premier élément thermoconducteur (33), l'extrémité froide (311) fait face à la bobine d'émission (20), et l'extrémité chaude (312) fait face au premier élément thermoconducteur (33).

3. Le dispositif de charge sans fil selon la revendication 1, dans lequel la première cavité (102) comprend un premier segment (1021) et un second segment (1022), le second segment (1022) s'étend vers le haut le long d'une courbe depuis le premier segment (1021) jusqu'à l'évent d'aération (101), le ventilateur (32) est situé dans le premier segment (1021), et la puce de réfrigération à semi-conducteur (31) est située dans le second segment (1022).

4. Le dispositif de charge sans fil selon la revendication 1, dans lequel le dispositif de charge sans fil (100) comprend en outre une carte de circuit imprimé (40), et
la carte de circuit imprimé (40) est électriquement connectée à la bobine d'émission (20), au ventilateur (32) et à l'autre ventilateur (32a), la carte de circuit imprimé (40) est disposée sur le boîtier (10a) et est située dans la troisième cavité (104), et l'air soufflé par l'autre ventilateur (32a) peut être soufflé vers le premier élément thermoconducteur (33) et la carte de circuit imprimé (40), et est évacué par l'évent d'échappement d'air (106).

5. Le dispositif de charge sans fil selon l'une quelconque des revendications 1 à 4, dans lequel le dispositif de charge sans fil (100) comprend en outre un second élément thermoconducteur (34), et le second élément thermoconducteur (34) est disposé entre la bobine d'émission (20) et la puce de réfrigération à semi-conducteur (31).

6. Le dispositif de charge sans fil selon la revendication 5, dans lequel l'ensemble de dissipation thermique (30) comprend en outre un troisième élément thermoconducteur (35), et le troisième élément thermoconducteur (35) est disposé entre la puce de réfrigération à semi-conducteur (31) et le premier élément thermoconducteur (33).

7. Le dispositif de charge sans fil selon la revendication 6, dans lequel le second élément thermoconducteur (34) ou le troisième élément thermoconducteur (35) est une structure thermoconductrice constituée d'un matériau thermoconducteur qui est déformable sous pression.

8. Le dispositif de charge sans fil selon l'une quelconque des revendications précédentes, dans lequel l'autre ventilateur (32a) et le premier élément thermoconducteur (33) sont disposés l'un par rapport à l'autre de telle sorte que l'air soufflé par l'autre ventilateur (32a) soit soufflé obliquement directement sur un côté couvercle ou base du premier élément thermoconducteur (33).
